(19) Europäisches Patentamt
European Patent Office
Office européen des brevets

(11) Veröffentlichungsnummer: **0 059 317**
**A1**

(12) **EUROPÄISCHE PATENTANMELDUNG**

(21) Anmeldenummer: 82100571.7

(22) Anmeldetag: 28.01.82

(51) Int. Cl.³: C 08 F 8/42
C 08 F 8/30, C 08 G 61/00
H 01 B 1/12, H 01 L 29/28
H 01 L 31/02

(30) Priorität: 07.02.81 DE 3104408

(43) Veröffentlichungstag der Anmeldung: 08.09.82 Patentblatt 82/36

(84) Benannte Vertragsstaaten: BE DE FR GB NL

(71) Anmelder: BASF Aktiengesellschaft
Carl-Bosch-Strasse 38
D-6700 Ludwigshafen(DE)

(72) Erfinder: Naarmann, Herbert, Dr.
15 Haardtblick
D-6719 Wattenheim(DE)

(72) Erfinder: Penzien, Klaus, Dr.
18 Bensheimer Ring
D-6710 Frankenthal(DE)

(72) Erfinder: Schlag, Johannes, Dr.
Leuschnerstrasse 36
D-6700 Ludwigshafen(DE)

(54) **Verfahren zur Herstellung von elektrisch leitfähigen Polymeren und deren Verwendung.**

(57) Verfahren zur Herstellung von elektrisch leitfähigen Polymeren mit elektrischen Leitfähigkeitswerten größer als $10^{-2}$S/cm und verbesserter Stabilität gegenüber Sauerstoff, wobei man organische ungesättigte Polymere aus der Reihe der Polyphenylene, Heteropolyphenylene und Polyacetylene unter Ausschluß von Wasserfeuchtigkeit und von Sauerstoff zunächst mit organischen Nitrosoverbindungen und anschließend mit üblichen Dotierungsmitteln, insbesondere einer starken Lewis-Säure mit $pk_s$-Werten von −10 bis +4 oder einer Base mit Elektronegativitäten nach Pauling bis 1,5 versetzt.

Als Lewis-Säure werden insbesondere die Verbindung $AsF_5$, $SbF_5$, $UF_6$, $SbCl_5$, $AlCl_3$, $BF_3$, $CF_3SO_3H$, $VOCl_3$, $HClO_4$, $NO^+SbF_6^-$, $NO^+SbF_6^-$, $NO^+AsF_6$, $NO^+PF_6^-$, $J_2$, $Br_2$, JCl, $PF_5^-$, $CrO_2Cl_2$, $NO^+PF_6^-$, $NO^+BF_4^-$, $NO^+ClO_4^-$,$(CF_3)_2SO_4$, $NbF_5$, $TaF_5$, $WF_6$, $FeCl_3$, $CdCl_2$, 2,4,6-Trinitrophenol, 2,4,6-Trinitrophenylsulfonsäure oder 2,4,6-Trinitrophenylcarbonsäure, als Basen Lithium, Natrium, Kalium, Calcium, Barium, Radium oder deren Amide zugesetzt.

Die hergestellten, elektrisch leitfähigen Polymeren können in der Elektrotechnik zur Herstellung von Sonnenzellen, zur Umwandlung und Fixierung von Strahlung, zur Herstellung elektrischer und magnetischer Schalter und Spreicher, und zur antistatischen Ausrüstung von Kunststoffen verwendet werden.

EP 0 059 317 A1

# Verfahren zur Herstellung von elektrisch leitfähigen Polymeren und deren Verwendung

Die Erfindung betrifft ein Verfahren zur Herstellung von elektrisch leitfähigen Polymeren mit elektrischen Leitfähigkeitswerten größer als $10^{-2}$ S/cm und verbesserter Stabilität gegen Sauerstoff sowie deren Verwendung in der Elektroindustrie zur Herstellung von Sonnenzellen, zur Umwandlung und Fixierung von Strahlung und zur Herstellung elektrischer und magnetischer Schalter und Speicher sowie zur antistatischen Ausrüstung von Kunststoffen.

Es ist bereits bekannt, organische Polymere aus der Reihe der Polyphenylene durch oxidative Kupplung entsprechend der Literatur: "Macromolecular Syntheses Collective" 1, (1979), Seiten 109 bis 110 und "Naturwiss." 56, (1969), Seiten 308 bis 313, herzustellen. Außerdem ist die Herstellung von Polyphenylenen durch stufenweise Polykondensation nach R. Gehm und W. Kern aus "Makromolekulare Chemie" 7, (1951), Seiten 46 bis 61, bekannt, wobei besonders einheitliche para-verkeetete methylsubstituierte Derivate erhalten werden, die nicht zusätzlich durch ortho- oder meta-verknüpfte Polymere verunreinigt sind. Die organischen Polymeren aus der Reihe der Heteropolyphenylene unterscheiden sich von den Polyphenylenen durch das Vorhandensein von Heteroatomen oder Heteroatome enthaltenen Gruppen zwischen den aromatischen Ringsystemen. Als Heteroatome kommen hierbei insbesondere Schwefel und Sauerstoff, aber auch Stickstoff, in Betracht. Diese Polymeren sind z.B. beschrieben in "Macromolecular Synthesis", 6, (1978), Seiten 45 bis 48. Auch die Herstellung der organischen Polymere aus der Reihe der Polyacetylene durch Polymerisation von Acetylen ist bekannt.

Sie ist z.B. in den Arbeiten von Hatano in "J. Chem. Soc. Japan, Ind. Chem. Sect." 65, (1962), Seite 723 ff. sowie von D.J. Berets et al. in "Trans. Farad. Soc." 64, (1968) Seite 823 ff, beschrieben. Auch in der neueren Publikation von H. Shirakawa et al., J. Chem. Soc., Chem. Comn." 1977, Seiten 578 bis 580 ist die Polymerisation von Acetylen zur Polyacetylen mit Hilfe von Ziegler-Katalysatoren beschrieben. Nach den genannten Methoden werden Produkte erhalten, die in den üblichen Lösungsmitteln vollkommen unlöslich sind und als schwarze amorphe bis teilkristalline Materialien anfallen. Auch die in der Literaturstelle "Ber. Bunsenges. Phys. Chem." 68, (1964), Seiten 558 bis 567 beschriebenen Materialien werden mit umfaßt.

Es ist weiterhin bekannt, diese Polyphenylene, Heteropolyphenylene oder Polyacetylene dadurch in elektrisch leitfähige Polymere zu überführen, daß man sie mit geeigneten Verbindungen dotiert. Übliche Dotierungsmittel sind dabei einerseits starke Lewis-Säuren mit $pk_s$-Werten von -10 bis +4 und andererseits Basen mit Elektronegativitäten nach Pauling bis 1,5 (vgl. z.B. DE-OSen 29 29 366 und 29 29 367 sowie EP-A3-0036118). Die so erhaltenen elektrisch leitfähigen Polymere besitzen jedoch nur eine geringe Stabilität gegenüber Sauerstoff und werden daher sehr leicht oxidativ geschädigt.

Der Erfindung lag die Afugabe zugrunde, die an sich bekannten organischen ungesättigten Polymeren aus der Reihe der Polyphenylene, Heteropolyphenylene oder Polyacetylene durch Zusätze in elektrisch leitfähige Polymere mit elektrischen Leitfähigkeitswerten größer als $10^{-2}$S/cm und erheblich verbesserter Stabilität gegen oxidative Schädigung umzuwandeln und so deren Verarbeitbarkeit und Anwendungsbreite deutlich zu erhöhen.

Die Aufgabe wird erfindungsgemäß dadurch gelöst, daß die organischen ungesättigten Polymeren aus der Reihe der Polyphenylene, Heteropolyphenylene oder Polyacetylene unter Ausschluß von Wasserfeuchtigkeit und von Sauerstoff zunächst mit einer organischen Nitroso-Verbindung in Mengen von 0,1 bis 10,5 Gew.-%, bezogen auf das Polymere, und anschließend mit 0,5 bis 55 Gew.-%, bezogen auf das eingesetzte organische Polymere, eines üblichen Dotierungsmittels, insbesondere einer starken Lewis-Säure mit $pk_s$-Werten von -10 bis +4 oder einer Base mit Elektronegativitäten nach Pauling bis 1,5 versetzt werden.

Beispiele für starke Lewis-Säuren mit $pk_s$-Werten von -10 bis +4 sind u.a. $AsF_5$, $UF_6$, $SbCl_5$, $AlCl_3$, $BF_3$, $CF_3SO_3H$, $VOCl_3$, $HClO_4$, $NO^+SbF_6^-$, $NO_2^+SbF_6^-$, $NO^+AsF_6^-$, $NO^+PF_6^-$, $I_2$, $Br_2$, ICl, $PF_5$, $CrO_2Cl_2$, $NO_2^+PF_6^-$, $NO^+BF_4^-$, $NO^+ClO_4^-$, $(CF_3)_2SO_4$, $NbF_5$, $TaF_5$, $WF_6$, $FeCl_3$, $CdCl_2$, 2,5,6-Trinitrophenol, 2,4,6-Trinitrophenylsulfonsäure und 2,4,6-Trinitophenylcarbonsäure. Beispiele für Basen mit Elektronegavitäten nach Pauling bis 1,5 sind u.a. Lithium, Natrium, Kalium, Rubidium, Calcium, Barium, Radium oder die Amide des Typs $MNH_2$, worin M Lithium, Natrium, Kalium oder Rubidium bedeutet.

Als organische Nitroso-Verbindungen können z.B. die folgenden Verbindungen eingesetzt werden: N-Nitroso-N-methylcarbamidsäure-ethylester, N-Nitroso-N-methyl-urethan, 1-Nitrosonaphthol-(2), 2-Nitrosonaphthol-(1), 4-Nitroso-N-phenylhydroxylamin-Ammoniumsalz (Kupferron), 2-Nitroso-toluol, 5-Nitroso-2,4,6-triaminopyrimidin, 3-Nitrosostyrol, ω-Nitrosostyrol, Nitrosobenzol, Nitroso-tert.-butan, N-Nitroso--dimethylamin, 4-Nitroso-N-dimethylanilin, N-(N-Nitrosomethylamino)-methyl-benzamid, 2-Nitroso-2-naphthol-3,6-disulfonsäure, N-Nitrosopyrrolidin, 4-Nitrosophenol, N-Nitrosophenylhydroxylamin-Ammoniumsalz.

Die in dem erfindungsgemäßen Verfahren einzusetzenden Polyphenyle können nach den eingangs erwähnten Methoden hergestellt werden. Ihr Molekulargewicht liegt dabei im allgemeinen im Bereich von etwa 250 bis 5000.

Als Heteropolyphenylene kommen insbesondere solche der allgemeinen Formel

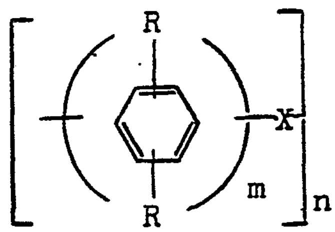

in Betracht, worin bedeuten

X: $SO_2$, S, O, NH, Se oder 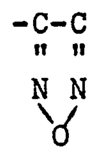 ,

R: H, $CH_3$, Phenyl oder Cyclohexyl

m: 1 bis 5, vorzugsweise 1 bis 2

n: 5 bis 1000, vorzugsweise 5 bis 500.

Bevorzugt sind Heteropolyphenylene mit einer S- oder O-Verknüpfung der Phenylringe in para-Stellung. Die Heteropolyphenylene weisen im allgemeinen ein Molekulargewicht von ca. 500 bis 500 000, vorzugsweise zwischen 1000 und 100 000, auf und können nach der eingangs zitierten Literatur hergestellt werden.

Die Herstellung der organischen Polymere aus der Reihe der Polyacetylene durch Polymerisation von Acetylen ist bekannt (vgl. eingangs zitierte Literatur).

Unter dem Begriff "organische Polymere aus der Reihe der Polyacetylene" sind dabei im Rahmen dieser Erfindung neben Polyacetylen selber, d.h. $(CH)_x$, auch Copolymerisate des Acetylens mit Di- und/oder Polyalkinen, z.B. Butadiin, Hexadiin oder Octadiin, sowie substituierte Polyacetylene zu verstehen, in denen wenigstens ein Teil der Wasserstoffatome an der Polymerkette durch Halogen (insbesondere Cl, Br oder I), niedere Alkylreste (insbesondere mit 1 bis 8 C-Atomen), Phenylreste (z.B. Phenyl, Halogenphenyl, Alkylphenyl) oder mehrere dieser Gruppen substituiert ist. Die organischen Polymere aus der Reihe der Polyacetylone weisen üblicherweise ein Molekulargewicht von etwa 2000 bis 100 000 auf.

Nach dem erfindungsgemäßen Verfahren werden den genannten ungesättigten Polymeren unter Ausschluß von Wasserfeuchtigkeit und von Sauerstoff zunächst 0,1 bis 10,5 Gew.-%, bezogen auf die eingesetzten Polymeren, der organischen Nitroso-Verbindungen und anschließend 0,5 bis 55 Gew.-%, bezogen auf die eingesetzten Polymeren, eines üblichen Dotierungsmittels, insbesondere einer starken Lewis-Säure mit $pk_s$-Werten von -10 bis +4 oder einer Base mit Elektronegativitäten nach Pauling bis 1,5 zugesetzt.

Bei der Behandlung der genannten ungesättigten Polymeren mit den organischen Nitroso-Verbindungen und den Dotierungsmitteln wird vorzugsweise unter Edelgas-Argonatmosphäre gearbeitet. Gegebenenfalls werden Hilfsflüssigkeiten wie Toluol, Tetrahydrofuran, Dimethoxyglykol, Nitromethan oder Methylenchlorid eingesetzt, die nach der Behandlung beispielsweise bei Temperaturen unter 30°C in Vakuum wieder abgezogen werden. Die organischen Nitroso-Verbindungen werden den ungesättigten Polymeren vorzugsweise in gelöster Form zugesetzt und bei Temperaturen von -100°C bis +100°C, vorzugsweise bei Temperaturen

im Bereich von 0°C bis 70°C, und Reaktionszeiten im allgemeinen von etwa 0,1 bis 5 Stunden zur Einwirkung gebracht. Die Einwirkung der organischen Nitrosoverbindungen kann dabei durch geeignete Maßnahmen, z.B. Schütteln im geschlossenen Gefäß, gefördert werden. Die zum Lösen der organischen Nitroso-Verbindungen verwendeten organischen Lösungsmittel können anschließend im Vakuum entfernt werden; zweckmäßig erfolgt jedoch das Zusetzen der Dotierungsmittel zu den ungesättigten, mit den organischen Nitroso-Verbindungen behandelten Polymeren vor dem Entfernen dieser Lösungsmittel. Die Umsetzung der mit den organischen Nitroso-Verbindungen behandelten ungesättigten Polymeren mit den Dotierungsmittel erolgt dabei in an sich bekannter und üblicher Art und Weise.

Durch das erfindungsgemäße Verfahren können elektrische Leitfähigkeitsanstiege von einigen Größenordnungen erreicht werden. Die erfindungsgemäß einzusetzenden organischen Polymeren haben Ausgangsleitfähigkeiten von weniger als $10^{-12}$S/cm, liefern aber nach der Behandlung mit den organischen Nitroso-Verbindungen und den Dotierungsmitteln Leitfähigkeiten größer als $10^{-2}$S/cm. Die elektrischen Leitfähigkeitswerte werden in S/cm bei 30°C gemessen, die Messung selbst erfolgt nach der Methode von F. Beck, "Berichte Bunsengesellschaft, Physikalische Chemie" <u>68</u> (1964), Seiten 558 bis 567.

Die erfindungsgemäß hergestellten elektrisch leitfähigen Polymeren haben nicht nur hohe elektrische Leitfähigkeitswerte größer als $10^{-2}$S/cm, sondern darüber hinaus auch eine stark verbesserte Stabilität gegenüber Sauerstoff und sind zur antistatischen Ausrüstung von Kunststoffen, zur Herstellung von Sonnenzellen, zur Umwandlung und Fixierung von Strahlung sowie zur Herstellung elektrischer und magnetischer Schalter und Speicher geeignet.

Durch die Dotierung mit starken Lewis-Säure entstehen sogenannte p-Leiter, durch die Dotierung mit Basen sogenannte n-Leiter.

Die in den folgenden Beispielen genannten Teile und Prozente beziehen sich, soweit nicht anders angegeben, auf das Gewicht.

Beispiele 1 bis 18

10 Teile des jeweiligen in der Tabelle angegebenen organischen Polymeren als Pulver oder Film werden unter Argon-atmosphäre und Ausschluß von Feuchtigkeit mit der jeweiligen gelösten organischen Nitroso-Verbindung versetzt, und später mit dem Dotierungsmittel (Lewis-Säure oder Base) umgesetzt. Die Messung der elektrischen Leitfähigkeit erfolgt nach F. Beck "Ber. Bunsenges. Phys. Chem." 68, (1964), Seiten 558 bis 567. In Beispiel 1 wird im einzelnen wie folgt bearbeitet:

10 Teile eines Polyacetylenfilms, hergestellt nach Shirakawa, werden mit 1 Teil (entspr. 10 %) N-Nitroso-N-methylurethan (II) und 100 Teilen Toluol versetzt und 3 Stunden bei 60°C geschüttelt, anschließend wird die Lösung abgegossen, mit Pentan (200 Teilen) gewaschen und 5 Stunden bei 0,1 Torr und 30°C getrocknet, dann wird der Film bei 50°C mit 5 Teilen $HClO_4$ (entspr. 50 %), eingesetzt als 70 %ige wäßrige Lösung, 6 Stunden behandelt. Der Cl-Wert ergibt umgerechnet den Einbau von 0,2 Mol % $ClO_4$.

In Beispielen 2 bis 18 wird analog wie in Beispiel 1 gearbeitet, wobei jeweils die in der Tabelle angegebenen Produkte eingesetzt werden. Die elektrisch leitfähigen Filme sind ohne erfindungsgemäße Behandlung mit den organischen Nitroso-Verbindungen bei Lagerung an der

Luft nur ca. 0,3 bis 2,5 Stunden stabil, dann sinkt die Leitfähigkeit laufend ab. Nach dem erfindungsgemäßen Verfahren werden stabilisierte Filme erhalten, deren Leitfähigkeit über Tage erhalten bleibt.

Die in den Beispielen eingesetzten organischen Nitroso--Verbindungen sind in der nachfolgenden Tabelle wie folgt bezeichnet:

| | |
|---|---|
| I | N-Nitroso-N-Methylcarbamidsäure-ethylester |
| II | N-Nitroso-N-Methylurethan |
| III | N-Nitroso-Naphthol-(2) |
| IV | N-Nitroso-naphthol-(1) |
| V | N-Nitroso-N-Phenylhydroxylamin-Ammoniumsalz |
| VI | 2-Nitroso-toluol |
| VII | 5-Nitroso-2,4,6-triaminopyridin |
| VIII | 3-Nitroso-styrol |

Tabelle

| Beispiel Nr. | organ. Polymeres Teile | Nitroso-Verbindung in % | Dotierungsmittel Art und Menge in % | Leitfähigkeit vor dem Zusatz | S/cm 30°C nach dem Zusatz |
|---|---|---|---|---|---|
| | 10 | | | | |
| 1 | Polyacetylen nach Shirkawa 1) | II 10 | $HClO_4$ 50 | $10^{-10}$ | $8,6 \cdot 10^{+2}$ |
| 2 | " | II 0,5 | $AsF_3$ 50 | $10^{-10}$ | $4,9 \cdot 10^{+2}$ |
| 3 | " | II 2 | $I_2$ 55 | $10^{-10}$ | $6,4 \cdot 10^{+2}$ |
| 4 | " | III 2 | $NO^+PF_6$ 10 | $10^{-10}$ | $6,9 \cdot 10^{+2}$ |
| 5 | " | III 10 | $CF_3COOH$ 25 | $10^{-10}$ | $3,8 \cdot 10^{+2}$ |
| 6 | " | IV 10 | $SbF_5$ 50 | $10^{-10}$ | $9,5 \cdot 10^{+2}$ |
| 7 | Polyacetylen nach Lüttinger 2) | I 1 | $HClO_4$ 30 | $10^{-10}$ | $3,2 \cdot 10^{+1}$ |
| 8 | Polyacetylen nach Shirakawa 1) | I 1 | $NbF_5$ 25 | $10^{-10}$ | $4,5 \cdot 10^{+1}$ |
| 9 | " | V 1 | $WF_6$ 30 | $10^{-10}$ | $2,1 \cdot 10^{+1}$ |
| 10 | " | VI 1 | $NO_2^+ClO_4$ 25 | $10^{-10}$ | $5,0 \cdot 10^{+2}$ |
| 11 | " | VII 1 | $H_2SO_4$ 10 | $10^{-10}$ | $3,8 \cdot 10^{+1}$ |
| 12 | wie Beisp. 1 | I 1 | Na 10 | $10^{-10}$ | $3,5 \cdot 10^{-1}$ |
| 13 | wie Beisp. 1 | II 2 | Naphthalin/Na 25 | $10^{-10}$ | $4,1 \cdot 10^{-1}$ |
| 14 | wie Beisp. 1 | III 5 | K 10 | $10^{-10}$ | $3,0 \cdot 10^{+1}$ |
| 15 | wie Beisp. 7 | IV 1 | -Methyl-styrol/Na 10 | $10^{-10}$ | $0,8 \cdot 10^{-1}$ |
| 16 | wie Beisp. 7 | V 2 | Li 10 | $10^{-10}$ | $0,8 \cdot 10^{-1}$ |
| 17 | wie Beisp. 7 | VI 7 | Ba 10 | $10^{-10}$ | $1,5 \cdot 10^{+1}$ |
| 18 | wie Beisp. 7 | VIII 10 | K 15 | $10^{-10}$ | $7,6 \cdot 10^{+1}$ |

1) J. Chem. Soc., Chem. Commn. 1977, Seiten 578 bis 580.

2) J. Org. Chem. 29 (1964) Seiten 2936 ff

Patentansprüche

1. Verfahren zur Herstellung von elektrisch leitfähigen Polymeren mit elektrischen Leitfähigkeitswerten größer als $10^{-2}$ S/cm, dadurch gekennzeichnet, daß man organische ungesättigte Polymere aus der Reihe der Polyphenylene, Heteropolyphenylene und Polyacetylene unter Ausschluß von Wasserfeuchtigkeit und von Sauerstoff zunächst mit organischen Nitrosoverbindungen in Mengen von 0,1 bis 10,5 Gew. %, bezogen auf das Polymere, und anschließend mit 0,5 bis 55 Gew.-%, bezogen auf das Polymere, eines an sich bekannten Dotierungsmittels versetzt.

2. Verfahren nach Anspruch 1, dadurch gekennzeichnet, daß man als Dotierungsmittel eine starke Lewis-Säure mit $pk_s$-Werten von -10 bis +4 oder eine Base mit Elektronegativitäten nach Pauling bis 1,5 zersetzt.

3. Verfahren nach Anspruch 2, dadurch gekennzeichnet, daß als Lewis-Säure die Verbindung $AsF_5$, $SbF_5$, $UF_6$, $SbCl_5$, $AlCl_3$, $BF_3$, $CF_3SO_3H$, $VOCl_3$, $HClO_4$, $NO^+SbF_6^-$, $NO_2^+SbF_6^-$, $NO^+AsF_6^-$, $NO^+PF_6^-$, $J_2$, $Br_2$, $JCl$, $PF_5$, $CrO_2Cl_2$, $NO_2^+PF_6^-$, $NO^+BF_4^-$, $NO^+ClO_4^-$, $(CF_3)_2SO_4$, $NbF_5$, $TaF_5$ $WF_6$, $FeCl_3$, $CdCl_2$, 2,4,6-Trinitrophenol, 2,4,6-Trinitrophenylsulfonsäure oder 2,4,6-Trinitrophenylcarbonsäure zugesetzt wird.

4. Verfahren nach Anspruch 2, dadurch gekennzeichnet, daß als Base Lithium, Natrium, Kalium, Calcium, Barium, Radium oder deren Amid zugesetzt wird.

5. Verwendung der nach Ansprüchen 1 bis 4 hergestellten, elektrisch leitfähigen Polymeren in der Elektrotechnik zur Herstellung von Sonnenzellen, zur Umwandlung und Fixierung von Strahlung und zur Herstellung elektrischer und magnetischer Schalter und Speicher.

6. Verwendung der nach Ansprüchen 1 bis 4 hergestellten, elektrisch leitfähigen Polymeren zur antistatischen Ausrüstung von Kunststoffen.

Europäisches Patentamt

**EUROPÄISCHER RECHERCHENBERICHT**

0059317

Nummer der Anmeldung

EP 82 10 0571

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl. 3) |
|---|---|---|---|
| A | EP-A-0 016 305 (ALLIED CHEMICAL)<br>* Ansprüche 1,3,9,10 *<br>--- | 1-6 | C 08 F 8/42<br>C 08 F 8/30<br>C 08 G 61/00<br>H 01 B 1/12<br>H 01 L 29/28<br>H 01 L 31/02 |
| A | US-A-4 204 216 (A.J. HEEGER)<br>* Ansprüche 1,2; Spalte 10, Zeilen 16-27 *<br>--- | 1,4,5 | |
| A | US-A-4 059 719 (E.W. BLAHA)<br>* Anspruch 1 *<br>----- | 1 | |

RECHERCHIERTE SACHGEBIETE (Int. Cl. 3)

C 08 F 8/42
C 08 F 8/30
H 01 B 1/12
H 01 L 29/28
H 01 L 31/02

Der vorliegende Recherchenbericht wurde für alle Patentansprüche erstellt.

| Recherchenort | Abschlußdatum der Recherche | Prüfer |
|---|---|---|
| DEN HAAG | 17-06-1982 | PERMENTIER W.A. |

KATEGORIE DER GENANNTEN DOKUMENTEN
X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument